# EUROPEAN PATENT APPLICATION

(11) **EP 4 733 332 A1**
(43) Date of publication of application: **29.04.2026**
(21) Application number: 23960659.3
(22) Date of filing: 20.12.2023
(51) Int. Cl.: C08F 210/16, C08F 210/14, C08F 4/659, C08F 4/642, C08F 4/643, C09J 123/08

(54) **ETHYLENE/A-OLEFIN COPOLYMER AND USE THEREOF**

(30) Priority: 04.12.2023 CN 202311638450
(71) Applicant: Wanhua Chemical Group Co., Ltd., Yantai, Shandong 264006 (CN)
(72) Inventor: WANG, Jinqiang, Chongqing Street, YEDA Yantai, Shandong 264006 (CN); ZHANG, Yanyu, Chongqing Street, YEDA Yantai, Shandong 264006 (CN); YANG, Ying, Chongqing Street, YEDA Yantai, Shandong 264006 (CN); JIAO, Dong, Chongqing Street, YEDA Yantai, Shandong 264006 (CN); LUO, Kexin, Chongqing Street, YEDA Yantai, Shandong 264006 (CN); LIN, Xiaojie, Chongqing Street, YEDA Yantai, Shandong 264006 (CN); WANG, Dalin, Chongqing Street, YEDA Yantai, Shandong 264006 (CN)
(74) Representative: Potter Clarkson
(86) International application number: PCT/CN2023/140205
(87) International publication number: WO 2025/118351

(57) **Abstract**

The present application relates to the technical field of olefin polymerization, and in particular relates to an ethylene/α-olefin copolymer and the use thereof. The ethylene/α-olefin copolymer has the following characteristics: (a) as measured by DSC, the melting peak temperature is 35-100°C, and the width of the melting range is 50-70°C; (b) dH(90) and dH(100) measured by means of successive self-nucleation/annealing (SSA) using a differential scanning calorimeter satisfy 0 ≤ dH(90) ≤ 2J/g and dH(100) = 0. When the copolymer of the present application is used for preparing a photovoltaic adhesive film, the processing efficiency at a relatively low processing temperatures is high, the number of crystal spots in a film product is small, and the requirements of most downstream application scenarios, especially the application requirements of a casting section mold, can be met.

## Description

### TECHNICAL FIELD

The present application relates to the technical field of olefin polymerization, specifically to an ethylene/α-olefin copolymer and application thereof.

### BACKGROUND

Polyolefins constitute the largest proportion of polymer materials, characterized by low cost, light specific weight, and ease of processing and molding, and are widely used in various fields such as industry, agriculture, military, and medicine. Polyethylene, a crucial product in the polyolefin industry, is currently the most widely produced type of general-purpose synthetic resin globally. Copolymers obtained through the copolymerization of ethylene and α-olefins exhibit the plasticity of plastics and the high elasticity of rubber, representing one of the primary directions for the development of high-end polyolefin materials.

Downstream applications have high requirements for ethylene/α-olefin copolymers, and their thermal properties have a significant impact on application scenarios. Especially during the film-forming process of ethylene/α-olefin copolymers, downstream users pay close attention to the number of crystal spots on the film, particularly in the field of photovoltaic adhesive films.

When preparing crosslinked photovoltaic adhesive films, due to the presence of crosslinking auxiliary agents in the formulation, if the processing temperature is too high, decomposition of the crosslinking auxiliary agents cannot be avoided during the film casting process, or crosslinking cannot be avoided during the casting process. Therefore, the casting temperature cannot be too high. However, a relatively low processing temperature limits the processing efficiency of the relevant polymers and also leads to an increased number of crystal spots in the resulting film. Therefore, it is particularly important to produce ethylene/α-olefin copolymers with specific properties to address the issues of processing efficiency at lower processing temperatures and controlling the number of crystal spots in film products.

The application document CN114466873A discloses an olefin-based polymer (ethylene/α-olefin copolymer), but it possesses high crystalline regions and exhibits a high-temperature peak in SSA, posing challenges for the processing of photovoltaic adhesive films. The application document CN109890854A discloses an ethylene/α-olefin copolymer with a relatively thick lamellar crystal thickness, but its thermal performance characteristics are not further clarified, potentially leading to application limitations in terms of thermal performance and transparency.

The application document WO 2007/136497 A2 discloses a method for preparing high molecular weight polymers by polymerizing ethylene and optionally one or more α-olefins under continuous solution polymerization conditions. The method involves polymerization under conditions that result in a polymerization index Ψ value, in the presence of a catalyst composition comprising a transition metal complex and an activating co-catalyst. This method addresses the issue of comonomer insertion, but does not involve research on related issues such as processing efficiency at low temperatures or crystal spots of film products.

Both application documents CN111943977A and CN111909196A utilize batch processes for the preparation of polymers. In the reaction kettle, the concentration of comonomers continuously decreases with reaction time, making it impossible to obtain a uniform polymer product. Additionally, the preparation methods disclosed in these two patent documents involve controlling the total pressure of the reaction kettle using ethylene pressure, and the ethylene concentration in the reaction kettle is the solubility at that pressure. Consequently, the ethylene concentration in the reaction kettle is relatively high, leading to a low conversion rate, making it difficult to achieve industrial production.

In view of this, it is highly necessary to develop a solution polymerization method for producing ethylene/α-olefin copolymers with specific properties.

### SUMMARY OF THE INVENTION

The following is an overview of the subject matter described in detail in the present application. This overview is not intended to limit the scope of protection of the claims.

To address the issues of excessive crystal spots and low processing efficiency in the film-forming process of ethylene/α-olefin copolymers, the present application provides an ethylene/α-olefin copolymer and application thereof. The copolymer exhibits unique properties, demonstrating high processing efficiency at lower processing temperatures when preparing photovoltaic adhesive films, and a small number of crystal spots in the film products. This meets the needs of most downstream application scenarios, in particular those of cast molding processes, and holds great industrial prospects.

In the first aspect, the present application provides an ethylene/α-olefin copolymer, which has the following characteristics:
(a) a melting peak temperature ranging from 35°C to 100°C (for example, 40°C, 45°C, 50°C, 55°C, 60°C, 80°C, 90°C, 95°C) and a melting range width ranging from 50°C to 70°C (for example, 52°C, 54°C, 55°C, 56°C, 58°C, 60°C, 62°C, 64°C, 65°C, 66°C, 68°C), as measured by differential scanning calorimetry (DSC); and
(b) dH(90) and dH(100) as measured by successive self-nucleation/annealing (SSA) using a differential scanning calorimetry, wherein 0 ≤ dH(90) ≤ 2J/g (for example, 0.01J/g, 0.05J/g, 0.1J/g, 0.2J/g, 0.4J/g, 0.5J/g, 0.8J/g, 1.0J/g, 1.2J/g, 1.5J/g, 1.8J/g), and dH(100) = 0.

The melting range of a polymer is a temperature interval, which is referred to as the melting range interval; the two limits are respectively called the initial melting temperature and the final melting temperature. The initial melting temperature is the temperature at which the substance begins to melt, and the final melting temperature is the temperature at which the substance is completely melted. In the present application, the melting range width is defined as the difference between the temperature at which the polymer is completely melted and the temperature at which it begins to melt, that is, the difference between T_{endset} and Tₒₙₛₑₜ.

In the present application, when the heat capacity of each segment is graded relative to the total heat capacity by integrating the temperature-heat capacity curve of each segment in the SSA measurement results obtained using a differential scanning calorimeter, dH(90) represents the sum of melting enthalpies above 90°C, and dH(100) represents the sum of melting enthalpies above 100°C.

According to the ethylene/α-olefin copolymer provided in the present application, in some embodiments, the ethylene/α-olefin copolymer further has the following characteristics:
(c) a density ranging from 0.855 g/cm³ to 0.910 g/cm³; for example, it may be 0.860 g/cm³, 0.865 g/cm³, 0.870 g/cm³, 0.875 g/cm³, 0.880 g/cm³, 0.885 g/cm³, 0.890 g/cm³, 0.895 g/cm³, 0.900 g/cm³, 0.905 g/cm³, or 0.908 g/cm³; and
(d) a weight-average molecular weight ranging from 40,000 g/mol to 200,000 g/mol (for example, 42,000 g/mol, 45,000 g/mol, 50,000 g/mol, 55,000 g/mol, 60,000 g/mol, 80,000 g/mol, 90,000 g/mol, 100,000 g/mol, 120,000 g/mol, 140,000 g/mol, 150,000 g/mol, 160,000 g/mol, and 180,000 g/mol), and a polymer dispersity index (PDI) of 2.3 to 3 (for example, 2.4, 2.5, 2.6, 2.8, and 2.9).

According to the ethylene/α-olefin copolymer provided in the present application, in some embodiments, the ethylene/α-olefin copolymer has a melting enthalpy of 20 J/g to 100 J/g, for example, 22 J/g, 25 J/g, 28 J/g, 30 J/g, 40 J/g, 50 J/g, 60 J/g, 80 J/g, 90 J/g, and 95 J/g.

In some embodiments, the ethylene/α-olefin copolymer has a melt index (MI) of 0.1 g/10 min to 30 g/10 min, for example, 0.15 g/10 min, 0.3 g/10 min, 0.5 g/10 min, 1.0 g/10 min, 2.0 g/10 min, 5.0 g/10 min, 8.0 g/10 min, 10 g/10 min, 12 g/10 min, 15 g/10 min, 18 g/10 min, 20 g/10 min, 25 g/10 min, and 28 g/10 min, at 190°C and a load of 2.16 kg.

In some embodiments, the ethylene/α-olefin copolymer has a glass transition temperature (Tg) of -65°C to -30°C, for example, -62°C, -60°C, -58°C, -55°C, -50°C, -45°C, -40°C, -35°C, and -32°C.

In some embodiments, in the ethylene/α-olefin copolymer, the α-olefin is a C3-C20 olefin or a mixture thereof, and optionally one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

In some embodiments, the ethylene/α-olefin copolymer is a product obtained by solution polymerization of ethylene with one or more α-olefins in the presence of a catalyst and optionally hydrogen as a chain transfer agent.

In some embodiments, in the solution polymerization reaction, the catalyst comprises a main catalyst and a co-catalyst.

In some embodiments, the main catalyst is a homogeneous catalyst selected from a metallocene catalyst or a non-metallocene catalyst.

The main catalyst may be selected from, but is not limited to, one or more of the following compounds: silyl(N-tert-butylamino)(tetramethylcyclopentadienyl)titanium dichloride, dimethylsilyl(N-tert-butylamino)(tetramethylcyclopentadienyl) titanium dimethyl, dimethylsilyl(N-tert-butylamino)(fluorenyl)titanium dichloride, pentamethylcyclopentadienyltitanium trimethoxide, diphenylmethylidene(cyclopentadienyl)(9-fluorenyl)zirconium dichloride, dimethyldimethylsilylbis(2-methyl-4-phenyl-1-indenyl)zirconium dichloride, meso-dimethylsilylbis(1-indenyl)zirconium dichloride, bis(methylcyclopentadienyl)zirconium dichloride, rac-ethylenebis(indenyl)zirconium dichloride, bis(1,3-dimethylcyclopentadienyl)zirconium dichloride, trichloro(cyclopentadienyl)(1,2-dimethoxyethane)zirconium, diphenylsilyl(cyclopentadienyl)(9-fluorenyl)zirconium dichloride, rac-dimethylsilylenebis(2-methylindenyl) zirconium dichloride, [1-(η5-cyclopentadien-1-yl)-1-(η5-2,7-di-tert-butylfluoren-9-yl)-1,1-diphenylmethane]zirconium dichloride, di(p-tolyl)methylene(η5-cyclopentadienyl){η5-(2,7-ditert-butylfluorenyl)}zirconium dichloride, dimethylbis(propylcyclopentadienyl)hafnium, bis(n-butyl cyclopentadiene) hafnium dichloride, (dimethylsilylene)bis(2-methyl-4-phenylindenyl)zirconium dichloride, and compounds represented by formulas (I) to (VIII) below. 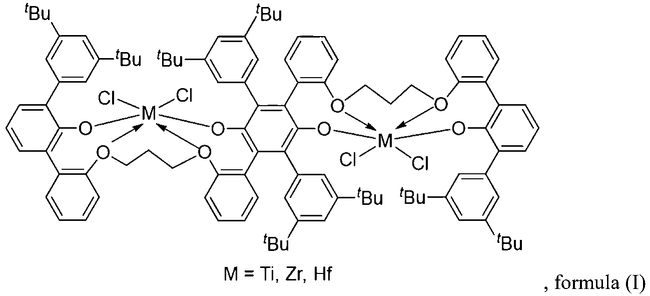 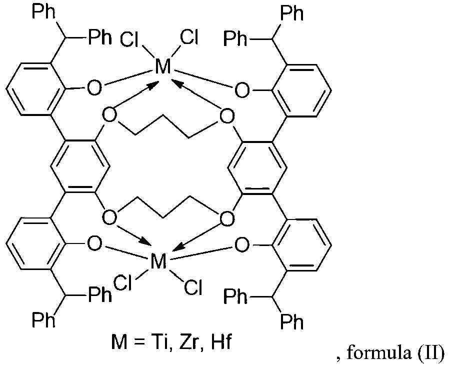 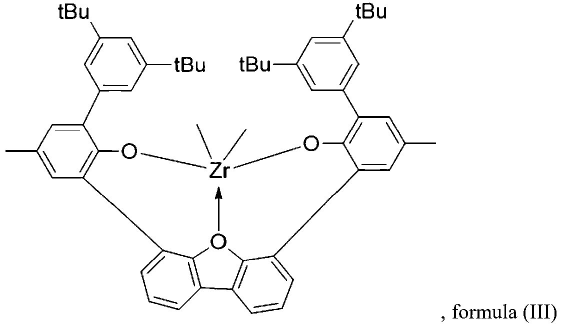 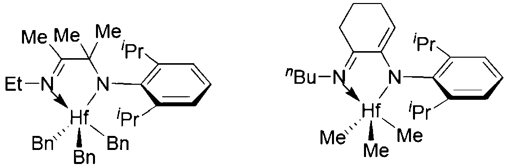 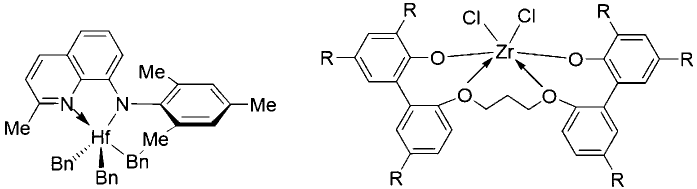 R is a C1-C30 alkyl, aryl, etc. , from left to right and from top to bottom, they are formula (IV) to formula (VIII) in sequence.

In some embodiments, the co-catalyst is one or more of aluminoxane, alkyl aluminum compound, and alkylaluminum chloride, or a composition comprising one or more of aluminoxane, alkyl aluminum compound, and alkylaluminum chloride, in combination with one or more organic borides; for example, the co-catalyst is a composition of aluminoxane and organic borides, a composition of alkyl aluminum compound and organic borides, or a composition of alkylaluminum chloride and organic borides.

In some embodiments, the aluminoxane is selected from the group consisting of methylaluminoxane (MAO) and modified methylaluminoxane (MMAO).

In some embodiments, the alkyl aluminum compound is selected from the group consisting of triethylaluminum, triisobutylaluminum, and trioctylaluminum.

In some embodiments, the alkylaluminum chloride is selected from the group consisting of diethylaluminum chloride, sesquiethylaluminum chloride, and aluminium ethyl dichloride.

In some embodiments, the organic boride is selected from the group consisting of triphenylmethylium tetrakis(perfluorophenyl)borate, tri(pentafluorophenyl)borane, N,N-dimethylanilinium tetra(pentafluorophenyl)borate, dioctadecylmethylamine tetra(pentafluorophenyl)borate, and di(hydrogenated tallow) methyl amine tetra(pentafluorophenyl)borate.

Furthermore, the molar ratio of metal aluminum in the co-catalyst to metal M in the main catalyst, Al/M, ranges from 3 to 1,000, for example, it may be 5, 10, 20, 50, 80, 100, 120, 140, 160, 180, 200, 300, 400, 500, 600, 700, 800, or 900, and optionally 10 to 100.

Furthermore, the molar ratio of the organic boride (on a boron basis) in the co-catalyst to the metal M in the main catalyst, B/M, ranges from 0 to 10, for example, it may be 0, 1, 1.5, 2, 2.5, 3, 3.5, 4, 4.5, 5, 6, 7, 8, 9, 9.5, etc., and optionally 1 to 3.

During the solution polymerization process, a solvent is also present. The solvent is in a liquid or supercritical state under the polymerization conditions. Optionally, the solvent is a hydrocarbon solvent. The liquid hydrocarbon solvent used is optionally selected from C5-12 hydrocarbons, which may be unsubstituted or substituted with C1-4 alkyl groups (e.g., one or more of pentane, methyl pentane, hexane, heptane, octane, cyclohexane, C6 mixed alkanes, methylcyclohexane, and hydrogenated naphtha). The solvent is more preferably selected from the group consisting of hexane, C6 mixed alkanes, methylcyclohexane, IsoparE, and the like.

In some embodiments, the solution polymerization reaction is carried out in one or more polymerization reactors. Suitable reactors may include, for example, non-stirred or stirred spherical, cylindrical, and tank-shaped containers, as well as circulation loop reactors and tubular reactors.

In some embodiments, when using a stirrer or circulating pump for mixing in the polymerization reactor, the Reynolds number Re is controlled to be in the range of 6,000 to 20,000 (for example, 6,500, 7,000, 7,500, 8,000, 8,500, 9,000, 10,000, 11,000, 112,000, 14,000, 15,000, 16,000, 18,000, 19,000), and optionally 6,000 to 10,000.

The Reynolds number is a function of the flow rate, viscosity, and density of the reaction mixture inside the polymerization reactor. Therefore, by controlling the Reynolds number, the material concentration distribution and temperature distribution within the polymerization reaction system can be comprehensively regulated, achieving integrated control of the system's flow rate, viscosity, and density. This enables the regulation and acquisition of polymers with specific performance characteristics, such as melting range width, dH(90), dH(100). For example, the Reynolds number can be controlled to adjust the temperature distribution and material concentration distribution inside the polymerization system, and to limit the viscosity and flow rate of the polymerization system, thereby achieving the production of polymers with specific performance characteristics.

In some embodiments, the solution polymerization reaction is carried out at 2 MPa to 10MPa (e.g., 2.2MPa, 2.5MPa, 3.0MPa, 3.5MPa, 4.0MPa, 4.5MPa, 5.0MPa, 5.5MPa, 6MPa, 7MPa, 8MPa, 9MPa), optionally at 2 MPa to 5MPa.

In some embodiments, the reaction temperature for the solution polymerization reaction ranges from 100°C to 220°C, such as 110°C, 120°C, 140°C, 150°C, 180°C, 200°C, and 210°C.

In the present application, ethylene/α-olefin copolymers can be prepared through conventional polymerization processes in the field. For example, using equipment related to solution polymerization reactions can also be conventional choices in the field, which will not be further elaborated here.

In the second aspect, the present application provides application of the ethylene/α-olefin copolymer as described above in the field of photovoltaic adhesive films.

The application of the ethylene/α-olefin copolymer in the field of photovoltaic adhesive films can be achieved through conventional operations in this field, which will not be elaborated here. For example, the prepared ethylene/α-olefin copolymer can be processed into a cast film through a casting process, and the casting equipment and process can be conventional choices in this field.

The ethylene/α-olefin copolymer described in the present application features a broad melting range and satisfies 0 ≤ dH(90) ≤ 2 J/g, indicating the absence of a high crystallization peak within the copolymer system. This facilitates easier melting, allowing for good processing at low temperatures. Due to the broadened melting range of the copolymer, particles can begin to melt partially even under relatively low temperatures during the feeding and initial conveying stages in the extruder. Complete melting can then be achieved in subsequent conveying without requiring excessively high temperatures, and without gel formation, thereby enhancing processing efficiency and enabling lower processing temperatures. Moreover, this property helps prevent the decomposition of auxiliary agent when they are incorporated. Additionally, the copolymer exhibits dH(100) = 0, confirming the absence of gel in the copolymer system. Consequently, during film casting process of the copolymer, the occurrence of crystal spots is significantly reduced or even eliminated.

Compared to existing related technologies, the superior effects of the technical solution of the present application lie at least in the following aspects: when the ethylene/α-olefin copolymer of the present application is used to prepare photovoltaic adhesive films, it exhibits high processing efficiency at relatively low processing temperatures, and the resulting film products have few or almost no crystal spots. This enables it to meet the requirements of most downstream application scenarios, particularly the demands of cast molding processes.

After reading and understanding the detailed description, other aspects can be clarified.

### DETAILED DESCRIPTION

To gain a detailed understanding of the technical features and contents of the present application, the following will provide a more comprehensive description of its alternative embodiments. Although the embodiments described in the examples illustrate alternative embodiments of the present application, it should be understood that the present application can be realized in various forms and should not be limited by the embodiments presented here.

Unless otherwise specified, the experimental procedures used in the following examples are conventional methods.

The materials, reagents, etc. used in the following examples can be obtained from commercial sources, and the specific information of some raw materials is as follows:
8660, ethylene/octene copolymer, purchased from Dow;
8688, ethylene/butylene copolymer, purchased from Dow;
IsoparE, 100% hydrogenated naphtha, purchased from Mobil;
Ethylene, polymerization grade, purchased from Air Liquide;
1-Octene, 98%, purchased from INEOS;
1-Hexene, 99%, purchased from Lingyan Biology;
1-Butene, 99%, purchased from Mingju;
rac-Ethylenebis(indenyl)zirconium dichloride, 99%, Strem, labeled as M1;
Dimethylsilyl(N-tert-butylamino)(tetramethylcyclopentadienyl) titanium dimethyl, 99%, purchased from Sinocompound, labeled as M2;
[1-(η5-cyclopentadien-1-yl)-1-(η5-2,7-di-tert-butylfluoren-9-yl)-1,1-diphenylmethane]zirconium dichloride, 98%, purchased from Honor Shine Chemical, labeled as M3;
The compound (M4) shown below was synthesized according to Example 16 recorded in patent document CN202010798198.8 (CN111943977B), and its structural formula is as follows: 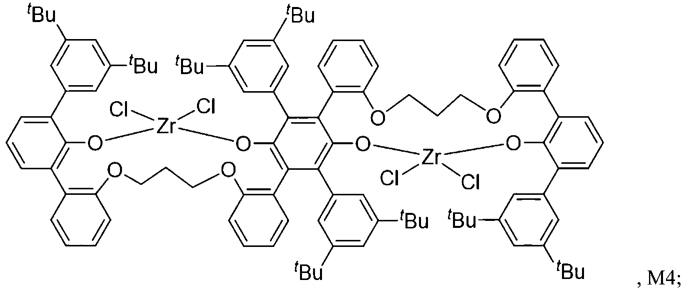
The compound (M5) shown below was synthesized according to Example 4 disclosed in patent document CN202010793023.8 (CN111909196B), and its structural formula is as follows: 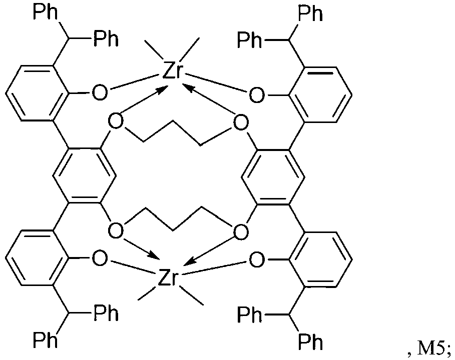
MMAO, a 7% aluminum solution, purchased from Nouryon;
MAO, a 15% aluminum solution, purchased from Albemarle;
Triisobutylaluminum (TIBA) hexane solution, 1 mol/L, purchased from Inno-Chem;
Triphenylmethylium tetrakis(perfluorophenyl)borate, 99%, purchased from Inno-Chem, dissolved in toluene for use, labeled as B1.

### <Test Method>

(1) In the following examples and comparative examples, the melting peak temperature (Tₘ) and melting enthalpy of the obtained polymers were tested using DSC, employing data obtained from the second heating cycle, with a heating and cooling rate of 10 °C/min. The melting range width is defined as the difference between the temperature at which the polymer is completely melted and the temperature at which melting begins, that is, the difference between T_{endset} and Tₒₙₛₑₜ.
(2) In the following examples and comparative examples, the SSA measurement of the obtained polymers was conducted using DSC. Specifically, in the first cycle, the temperature was raised to 150°C, maintained for 1 minute, and then lowered to -50°C; in the second cycle, the temperature was raised to 120°C, maintained for 5 minutes, and then lowered to -50°C; in the third cycle, the temperature was raised to 112.5°C, maintained for 5 minutes, and then lowered to -50°C; the process of temperature elevation and maintenance for 5 minutes followed by temperature reduction was repeated for the fourth cycle (i.e., during the temperature elevation in the fourth cycle, the temperature was raised at intervals of 7.5°C to a maximum of 105°C and maintained for 5 minutes before cooling down to -50°C), the fifth cycle (i.e., during the temperature elevation in the fifth cycle, the temperature was raised at intervals of 7.5°C to a maximum of 97.5°C and maintained for 5 minutes before cooling down to -50°C), the sixth cycle, and so on, until the temperature reached -40°C, thus crystallizing in each temperature interval. In the final cycle, the temperature was raised to 150°C at a rate of 10°C/min, and the heat capacity was measured. dH(90) represents the sum of the melting enthalpies above 90°C, and dH(100) represents the sum of the melting enthalpies above 100°C.
(3) In the following examples and comparative examples, the density of the obtained polymer was tested using a densitometer; the sample pieces to be tested were cut from the lamination plate, and the density was tested using a densitometer Mettler XS204, employing the impregnation method with anhydrous ethanol AR as the impregnation liquid; the test environment temperature was 23°C±2°C, and the test temperature required internal calibration for acquisition; the mass of the sample to be tested was >1g, with no bubbles; the mass of the sample in air and the mass of the sample in the impregnation liquid were weighed separately, and the density of the sample to be tested was calculated and derived using Archimedes' principle.
(4) In the following examples and comparative examples, the molecular weight, molecular weight distribution, and insertion rate of α-olefins (such as 1-octene) of the obtained polymers were determined using GPC-IR from Polymer Char at a testing temperature of 150°C. The product recovery rate exceeded 95%.
(5) In the following examples and comparative examples, the melt index (MI) of the obtained polymer was tested under the conditions of 190°C and a load of 2.16kg: taking 4-8g of granular material to be tested, setting the temperature to 190°C, the load to 2.16kg, and the standard die inner diameter to 2.095mm; melting the granular material in the barrel for 5 minutes followed by flowing it out of the die under the applied pressure and load; measuring and recording the time taken for the displacement point to move from 46mm to 20.6mm; automatically cutting the sample strip, and weighing the mass of the sample strip using a balance; and calculating the MFR or MVR, with units of g/10min and cm³/10min, respectively.

The ethylene/α-olefin copolymers in each example and comparative example were prepared on a continuous reaction platform equipped with reactors of different volumes and types. The operational steps were as follows:
The reactor was purged of impurities by continuously introducing dried solvent and operating for 2 days. Then, α-olefin comonomer, solvent, main catalyst, and co-catalyst were introduced into the reactor in sequence. Stirring was initiated, the system was heated, and ethylene monomer at 3 MPa to 9 MPa was introduced for polymerization reaction; wherein:
The reactions were conducted according to the polymerization reaction conditions shown in Tables 1 to 3, respectively (by feeding specific solvents, ethylene, α-olefin comonomers, main catalysts, and co-catalysts into the reactor at a certain feed flow rate, while controlling certain reaction pressure, reaction temperature, and Reynolds number for mixing). After the obtained reaction mixture underwent subsequent processes (removal of volatile components, drying, followed by extrusion and granulation), specific ethylene/α-olefin copolymer product particles were obtained. Wherein:
The volatile components in the reaction mixture were removed through flash evaporation; extrusion and granulation were carried out using a twin-screw extruder, with an extrusion temperature ranging from 80°C to 260°C and a screw speed of 30 rpm to 150 rpm.

The characteristic test results of the products prepared in each example and comparative example are shown in Tables 4 and 5.

**Table 1 Polymerization reaction conditions for each example and comparative example**

| | Reactor type | Reactor volume (L) | Solvent type | Solvent feed rate (kg/h) | Ethylene feed rate (kg/h) | Type of comonomer | Comonomer feed rate (kg/h) |
|---|---|---|---|---|---|---|---|
| Example 1 | Stirred tank reactor | 2 | IsoparE | 8.46 | 1.37 | 1-Octene | 3.5 |
| Example 2 | Stirred tank reactor | 15 | C6 mixed alkanes | 76.81 | 14.17 | 1-Butene | 26.67 |
| Example 3 | Stirred tank reactor | 15 | IsoparE | 60.22 | 13.04 | 1-Hexene | 32 |
| Example 4 | Circulating tubular reactor | 25 | Methylcyclohexane | 85.07 | 22.83 | 1-Octene | 50 |
| Example 5 | Circulating tubular reactor | 25 | C6 mixed alkanes | 67.33 | 26.09 | 1-Octene | 31.58 |
| Example 6 | Circulating tubular reactor | 25 | Hexane | 69.53 | 16.84 | 1-Octene | 50 |
| Comparative Example 1 | Stirred tank reactor | 15 | IsoparE | 60.22 | 13.04 | 1-Hexene | 32 |
| Comparative Example 2 | Stirred tank reactor | 15 | IsoparE | 60.22 | 13.04 | 1-Hexene | 32 |

**Table 2 Polymerization reaction conditions for each example and comparative example**

| | Type of main catalyst | Amount of main catalyst added (µmol/h) | Type of co-catalyst | Al/M | Type of organic boride | B/M |
|---|---|---|---|---|---|---|
| Example 1 | M1 | 20 | MMAO | 500 | - | - |
| Example 2 | M2 | 285.7 | MMAO | 200 | - | - |
| Example 3 | M3 | 400 | MAO | 1,000 | - | - |
| Example 4 | M4 | 150 | TIBA | 3 | B1 | 1 |
| Example 5 | M5 | 500 | MMAO | 50 | - | - |
| Example 6 | M4 | 375 | TIBA | 5 | B1 | 3 |
| Comparative Example 1 | M3 | 400 | MAO | 1,000 | - | - |
| Comparative Example 2 | M3 | 400 | MAO | 1,000 | - | - |

**Table 3 Polymerization reaction conditions for each example and comparative example**

| | Reynolds number | Reaction temperature (°C) | Reaction pressure (MPa) |
|---|---|---|---|
| Example 1 | 6,000 | 140 | 5 |
| Example 2 | 8,000 | 165 | 8 |
| Example 3 | 10,000 | 135 | 4 |
| Example 4 | 9,000 | 120 | 6 |
| Example 5 | 7,000 | 195 | 3 |
| Example 6 | 7,500 | 170 | 10 |
| Comparative Example 1 | 500 | 135 | 4 |
| Comparative Example 2 | 200,000 | 135 | 4 |

**Table 4 Characteristic test results of polymers prepared in each example and comparative example**

| | Density (g/cm³) | Mw (g/mol) | PDI | MI (19°C, 2.16kg) (g/10min) | Glass transition temperature Tg (°C) |
|---|---|---|---|---|---|
| Example 1 | 0.865 | 75,000 | 2.3 | 6.1 | -60 |
| Example 2 | 0.862 | 51,000 | 2.7 | 15 | -57 |
| Example 3 | 0.860 | 110,000 | 2.8 | 1.2 | -58 |
| Example 4 | 0.878 | 192,000 | 2.4 | 0.14 | -54 |
| Example 5 | 0.905 | 42,000 | 2.2 | 28 | -45 |
| Example 6 | 0.855 | 49,000 | 2.4 | 18 | -51 |
| Comparative Example 1 | 0.861 | 10,900 | 2.7 | 1.3 | -57 |
| Comparative Example 2 | 0.859 | 11,450 | 2.6 | 1.2 | -56 |
| Comparative Example 3 (Commercial ethylene/octene copolymer 8660) | 0.872 | 69,000 | 2.4 | 5 | -54 |
| Comparative Example 4 (Commercial ethylene/butene copolymer 8680) | 0.870 | 54,000 | 2.4 | 14 | -53 |

**Table 5 Characteristic test results of polymers prepared in each example and comparative example**

| | Melting peak temperature Tₘ (°C) | Melting range width (°C) | dH(90) | dH(100) | Melting enthalpy (J/g) |
|---|---|---|---|---|---|
| Example 1 | 55 | 58 | 0.1 | 0 | 59 |
| Example 2 | 50 | 64 | 0.1 | 0 | 53 |
| Example 3 | 45 | 63 | 0 | 0 | 43 |
| Example 4 | 75 | 66 | 1.0 | 0 | 65 |
| Example 5 | 98 | 69 | 1.8 | 0 | 95 |
| Example 6 | 35 | 50 | 0 | 0 | 20 |
| Comparative Example 1 | 44 | 108 | 5 | 2 | 68 |
| Comparative Example 2 | 46 | 48 | 0 | 0 | 42 |
| Comparative Example 3 (Commercial ethylene/octene copolymer 8660) | 72 | 74 | 3 | 0 | 52 |
| Comparative Example 4 (Commercial ethylene/butylene copolymer 8680) | 62 | 73 | 2.8 | 0 | 44 |

Furthermore, the copolymers from the aforementioned examples and comparative examples were cast into films on a casting machine (equipped with a single screw extruder, L/D=35, screw diameter 30mm) at a processing temperature of 110°C, with a controlled film thickness of 0.6mm.

After obtaining the cast film, the number of crystal spots on the cast film and the film processing efficiency were tested. Wherein the number of crystal spots was tested according to the ASTM D3351 standard, and the processing efficiency was represented by the length of the film formed per 10-minute interval. The relevant test results are shown in Table 6.

**Table 6: Test of number of crystal spots and casting efficiency of ethylene/α-olefin copolymer after cast film formation**

| Ethylene/α-olefin copolymer cast film | Number of crystal spots (pcs) | Cast film processing efficiency (m/10min) |
|---|---|---|
| Example 1 | 0 | 12.5 |
| Example 2 | 0 | 12.7 |
| Example 3 | 0 | 13 |
| Example 4 | 1 | 11.8 |
| Example 5 | 1 | 11.2 |
| Example 6 | 0 | 12.6 |
| Comparative Example 1 | 4 | 10.8 |
| Comparative Example 2 | 1 | 10.6 |
| Comparative Example 3 (Commercial ethylene/octene copolymer 8660) | 1 | 9.4 |
| Comparative Example 4 (Commercial ethylene/butylene copolymer 8680) | 1 | 9.1 |

As shown in Table 6, after the ethylene/α-olefin copolymers prepared in each example of the present application were used to prepare cast films, the number of crystal spots in the films was significantly less than that of the cast films made from copolymers obtained in Comparative Examples 1 and 2. The processing efficiency during the casting process was notably faster than that of Comparative Examples 3 and 4, indicating that the ethylene/α-olefin copolymers of the present application possess unique characteristics, resulting in a significant reduction in the number of crystal spots in the cast films made from the copolymers and a notable improvement in processing efficiency.

The examples of the present application have been described above. The above description is exemplary and not exhaustive, and is not limited to the disclosed examples. Many modifications and variations are apparent to those ordinary skilled in the art without departing from the subject of the present application.

## Claims

1. An ethylene/α-olefin copolymer, wherein the ethylene/α-olefin copolymer has the following characteristics:
(a) a melting peak temperature ranging from 35°C to 100°C and a melting range width ranging from 50°C to 70°C, as measured by differential scanning calorimetry (DSC); and
(b) dH(90) and dH(100) as measured by successive self-nucleation/annealing (SSA) using a differential scanning calorimetry, wherein 0 ≤ dH(90) ≤ 2J/g and dH(100) = 0.

2. The ethylene/α-olefin copolymer according to claim 1, wherein the ethylene/α-olefin copolymer further has the following characteristics:
(c) a density ranging from 0.855 g/cm³ to 0.910 g/cm³; and
(d) a weight-average molecular weight ranging from 40,000 g/mol to 200,000 g/mol, and a polymer dispersity index (PDI) ranging from 2.3 to 3.

3. The ethylene/α-olefin copolymer according to claim 1, wherein the ethylene/α-olefin copolymer has a melting enthalpy ranging from 20 J/g to 100 J/g.

4. The ethylene/α-olefin copolymer according to claim 1, wherein the ethylene/α-olefin copolymer has a melt index (MI) ranging from 0.1 g/10 min to 30 g/10 min under the conditions of 190°C and a load of 2.16 kg.

5. The ethylene/α-olefin copolymer according to claim 1, wherein the ethylene/α-olefin copolymer has a glass transition temperature (Tg) ranging from -65°C to -30°C.

6. The ethylene/α-olefin copolymer according to claim 1, wherein the α-olefin in the ethylene/α-olefin copolymer is a C3-C20 olefin or a mixture thereof.

7. The ethylene/α-olefin copolymer according to claim 6, wherein the α-olefin is one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, and 1-eicosene.

8. The ethylene/α-olefin copolymer according to claim 1, wherein the ethylene/α-olefin copolymer is a product obtained by solution polymerization reaction of ethylene with one or more α-olefins in the presence of a catalyst and optionally hydrogen as a chain transfer agent.

9. The ethylene/α-olefin copolymer according to claim 8, wherein the catalyst comprises a main catalyst and a co-catalyst;
the main catalyst is a homogeneous catalyst selected from metallocene catalysts or non-metallocene catalysts; and/or
the co-catalyst is one or more of aluminoxane, alkyl aluminum compounds, and alkylaluminum chloride, or a composition comprising one or more of aluminoxane, alkyl aluminum compound, and alkylaluminum chloride, in combination with one or more organic borides.

10. The ethylene/α-olefin copolymer according to claim 9, wherein,
the aluminoxane is selected from the group consisting of methylaluminoxane and modified methylaluminoxane; and/or
the alkyl aluminum compound is selected from the group consisting of triethylaluminum, triisobutylaluminum, and trioctylaluminum; and/or
the alkylaluminum chloride is selected from the group consisting of diethylaluminum chloride, sesquiethylaluminum chloride, and aluminium ethyl dichloride; and/or
the organic boride is selected from the group consisting of triphenylmethylium tetrakis(perfluorophenyl)borate, tri(pentafluorophenyl)borane, N,N-dimethylanilinium tetra(pentafluorophenyl)borate, dioctadecylmethylamine tetra(pentafluorophenyl)borate, and di(hydrogenated tallow) methyl amine tetra(pentafluorophenyl)borate.

11. The ethylene/α-olefin copolymer according to claim 8, wherein the solution polymerization reaction is carried out in one or more polymerization reactors; and/or
when using a stirrer or circulating pump for mixing in the polymerization reactor, the Reynolds number Re is controlled to be in the range of 6,000 to 20,000.

12. The ethylene/α-olefin copolymer according to claim 8, wherein the solution polymerization reaction is carried out at 2 MPa to 10 MPa.

13. Application of the ethylene/α-olefin copolymer according to any one of claims 1 to 12 in the field of photovoltaic adhesive films.
